# EUROPEAN PATENT APPLICATION

(11) **EP 3 128 471 A1**
(43) Date of publication of application: **08.02.2017**
(21) Application number: 16182328.1
(22) Date of filing: 02.08.2016
(51) Int. Cl.: G06Q 10/08

(54) **METHOD AND APPARATUS FOR PROVIDING PALLET LOADING GUIDE**

(30) Priority: 03.08.2015 KR 20150109416
(71) Applicant: Samsung SDS Co., Ltd., Songpa-gu, Seoul (KR)
(72) Inventor: KIM, Bum Jin, Seoul (KR); KIM, Dong Hun, Seoul (KR); YOON, Ki Seop, Seoul (KR); SONG, Jin Woo, Seoul (KR); NOH, Han Gyul, Seoul (KR); SHIM, Eui Kyu, Seoul (KR)
(74) Representative: Grünecker Patent- und Rechtsanwälte PartG mbB

(57) **Abstract**

Guide providing methods and an operator device are provided, one of methods comprises, acquiring item dimensions information and item constraint information of items and gallet dimensions information and pallet constraint information of pallets, classifying items into a plurality of item groups based on the acquired information, matching each of the item groups with a pallet for loading items included in a corresponding item group, when all items included in multiple item groups can be loaded together on a single pallet, merging the multiple item groups based on a remaining area of the matched pallet, performing a simulated loading of items included in each of the item groups on the pallet matched to a corresponding item group by changing loading sequences and arrangements, and determining a loading sequence and arrangement for loading the items included in each of the item groups on the pallet matched to the corresponding item group.

## Description

This application claims priority to Korean Patent Application No. 10-2015-0109416 filed on August 3, 2015 in the Korean Intellectual Property Office, the disclosure of which is incorporated herein by reference in its entirety.

### BACKGROUND

### 1. Field of the Invention

The present disclosure relates to a method and apparatus for providing a pallet loading guide, and more particularly, to a guide providing method and apparatus for providing a guide to an efficient loading of items on pallets.

### 2. Description of the Related Art

Ever since the Industrial Revolution that enabled mass production, most products have been made to be produced in multiple factories, delivered for sale to multiple vendors, and purchased at multiple locations. Thus, solutions for the delivery or transfer of products have become one of the most important factors to be considered in various businesses.

In general, products come in various shapes and are generally delivered by being loaded on pallets under various constraints. Accordingly, the number of pallets used in the delivery of products, which directly affects the delivery cost of the products, may considerably vary depending on operators' level of competence.

Therefore, various solutions are needed for delivering products using a minimum number of pallets without regard to operators' level of competence.

### SUMMARY

Exemplary embodiments of the present disclosure provide a guide providing method and apparatus for providing a guide to the loading of items on a minimum number of pallets over a minimum pallet area.

However, exemplary embodiments of the present disclosure are not restricted to those set forth herein. The above and other exemplary embodiments of the present disclosure will become more apparent to one of ordinary skill in the art to which the present disclosure pertains by referencing the detailed description of the present disclosure given below.

According to an Exemplary embodiment of the present disclosure, a guide providing method comprises, acquiring item dimensions information and item constraint information of items and pallet dimensions information and pallet constraint information of pallets, classifying items into a plurality of item groups based on the acquired information, matching each of the item groups with a pallet for loading items included in a corresponding item group, when all items included in multiple item groups can be loaded together on a single pallet, merging the multiple item groups based on a remaining area of the matched pallet, performing a simulated loading of items included in each of the item groups on the pallet matched to a corresponding item group by changing loading sequences and arrangements, and determining a loading sequence and arrangement for loading the items included in each of the item groups on the pallet matched to the corresponding item group.

According to another exemplary embodiment of the present disclosure, a guide providing method comprises, receiving item identifier and item constraint information of items and pallet identifier and pallet constraint information of a pallet, transmitting the received identifiers and information to a simulation server, receiving a loading sequence and arrangement for loading the items on the pallet from the simulation server, and providing a step-by-step guide screen for loading the items on the pallet according to the received loading sequence and sequence.

According to other exemplary embodiment of the present disclosure, an operator device comprises, a device input unit receiving data from an operator who loads items on a pallet, a device communication unit transmitting data to or receiving data from a simulation server via a network, a device output unit outputting an image showing the pallet with the items loaded thereon, and a device control unit receiving item identifiers and item constraint information of the items and a pallet identifier and pallet constraint information of the pallet via the device input unit, transmitting the received identifiers and information and receiving a loading sequence and arrangement for loading the items on the pallet via the device communication unit, and outputting a step-by-step guide screen for loading the items on the pallet via the device output unit.

According to the exemplary embodiments, a loading sequence and arrangement for loading items on a minimum number of pallets over a minimum pallet area are provided, and thus, the use of loading space and the stability of items loaded in the loading space can be improved.

Also, a step-by-step guide screen is provided so as for operators to easily load items on pallets, and thus, the operators' performance and efficiency can be improved.

Other features and aspects will be apparent from the following detailed description, the drawings, and the claims.

### BRIEF DESCRIPTION OF THE DRAWINGS

FIG. 1 is a schematic view illustrating a simulation system according to an exemplary embodiment of the present disclosure.
FIG. 2 is a flowchart illustrating a guide providing method according to an exemplary embodiment of the present disclosure.
FIG. 3 is a flowchart illustrating a method of classifying items according to an exemplary embodiment of the present disclosure.
FIG. 4 is a flowchart illustrating a simulated loading method according to an exemplary embodiment of the present disclosure.
FIG. 5 is a schematic view illustrating a pallet matching method according to an exemplary embodiment of the present disclosure.
FIG. 6 is a schematic view illustrating a method of merging item groups according to an exemplary embodiment of the present disclosure.
FIG. 7 is a schematic view illustrating an item arrangement pattern according to an exemplary embodiment of the present disclosure.
FIG. 8 is a schematic view illustrating the center of gravity of a pallet according to an exemplary embodiment of the present disclosure.
FIG. 9 is a flowchart illustrating a guide providing method according to another exemplary embodiment of the present disclosure.
FIGS. 10 through 12 are schematic views illustrating guide screens according to some exemplary embodiments of the present disclosure.
FIG. 13 is a block diagram of a simulation server according to an exemplary embodiment of the present disclosure.
FIG. 14 is a block diagram of an operator device according to an exemplary embodiment of the present disclosure.
FIG. 15 is a hardware configuration view of the simulation server of FIG. 13.

### DETAILED DESCRIPTION OF THE EMBODIMENTS

Terms used in the present disclosure are defined as follows.

Items are objects transferred from a first location to a second location. Any objects delivered for transfer, rental, import, export, or exhibition purposes are referred to as items, but the present disclosure is not limited thereto. For example, items may be products delivered from a first country to a second country to be exported, but the present disclosure is not limited thereto. Pallets are tools for loading and carrying items thereon for an effective delivery of the items.

Pallets may be carried by being lifted by the forks of forklift trucks, but the present disclosure is not limited thereto. Pallets may not include any wheels, but the present disclosure is not limited thereto. Pallets may be formed of a plastic material, but the present disclosure is not limited thereto. That is, alternatively, pallets may be formed of a wood or metal material.

Items may be loaded in layers on a pallet. A single pallet may have a plurality of layers. A plurality of items may be loaded on a pallet to form a plurality of layers, but the present disclosure is not limited thereto. That is, alternatively, a plurality of items may be loaded in a single layer.

Exemplary embodiments of the present disclosure will hereinafter be described with reference to the accompanying drawings.

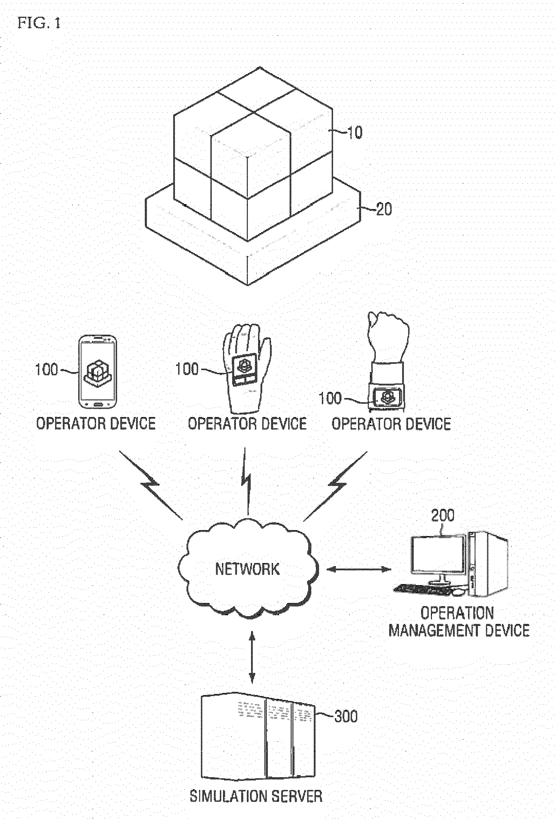

FIG. 1 is a schematic view illustrating a simulation system according to an exemplary embodiment of the present disclosure. The elements of the simulation system of FIG. 1 are functional elements that are functionally separate from one another and may be integrated into fewer elements in an actual physical environment.

Referring to FIG. 1, the simulation system may include one or more operator devices 100, an operation management device 200, and a simulation server 300. The operator devices 100, the operation management device 200, and the simulation server 300 will hereinafter be described.

The operator devices 100 are devices providing a guide screen for facilitating the loading of one or more items 10 on a pallet 20.

More specifically, the operator devices 100 may be used by operators who load the items 10 on the pallet 20. The operator devices 100 may receive a loading sequence and arrangement for loading the items 10 on the pallet 20 from the simulation server 300. The operator devices 100 may provide the guide screen according to the received loading sequence and arrangement.

The guide screen is a screen displaying the process of sequentially loading the items 10 on the pallet 20. The guide screen may include step-by-step images showing the loading of the items 10 on the pallet 20. The guide screen may include a three-dimensional (3D) image making the arrangement of the items 10 on the pallet 20 easily recognizable, but the present disclosure is not limited thereto. That is, alternatively, the guide screen may include a plurality of two-dimensional (2D) images. Also, the guide screen may include a guide string for selecting a first item 10 and loading the first item 10 at a first location on the pallet 20.

Also, the guide screen may further include an image showing the center of gravity of the pallet 20 with the items 10 loaded thereon. Also, the guide screen may include an image of a tiedown for fixing the items 10 onto the pallet 20.

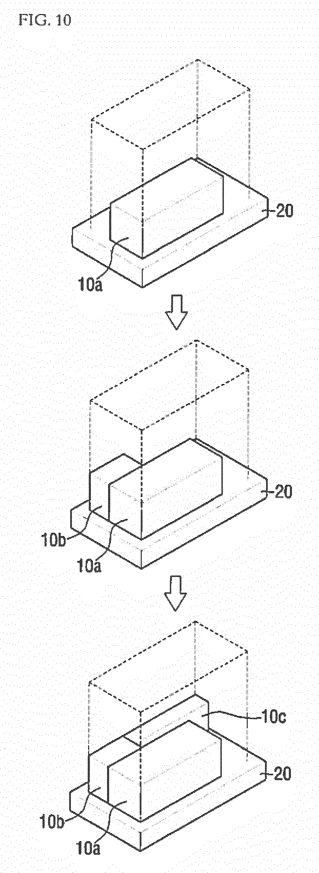

Examples of the guide screen will be described later in detail with reference to FIGS. 10 through 12.

The operator devices 100 may be mobile devices such as, for example, smartphones, laptops, tablets, phablets, or personal digital assistants (PDAs), but the present disclosure is not limited thereto. That is, alternatively, the operator devices 100 may be wearable devices such as, for example, smart bands, smart watches, smart rings, or pairs of smart glasses. Alternatively, the operator devices 100 may be attached to the sides of the gloves worn by the operators when loading the items 10 on the pallet 20.

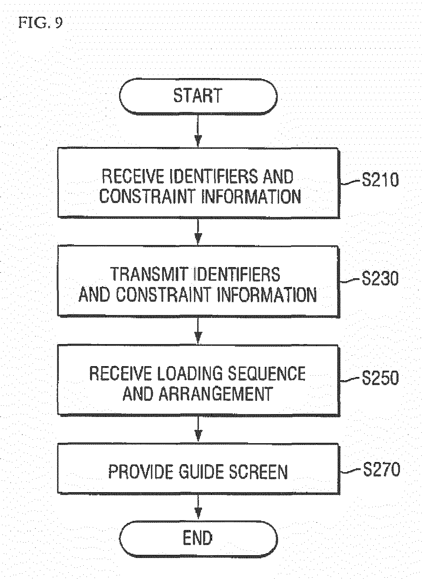

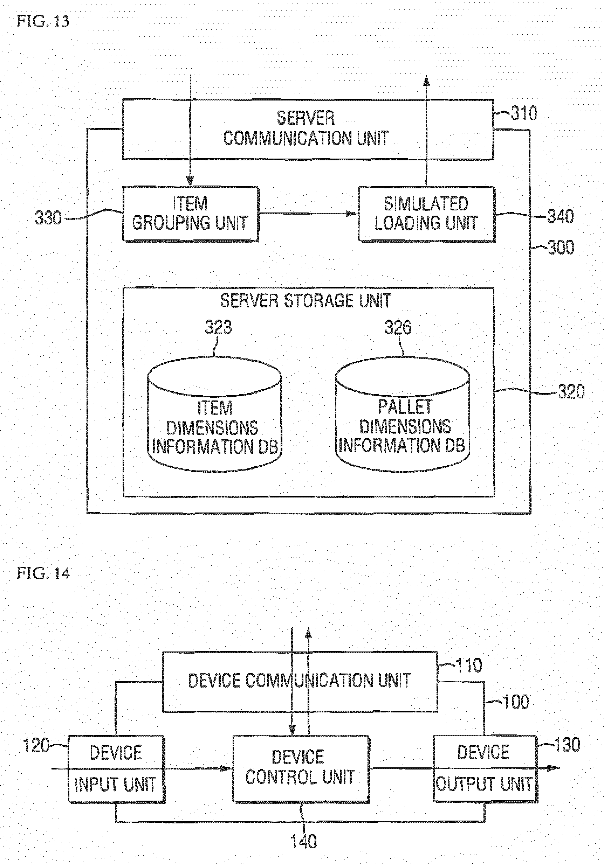

The operator devices 100 will be described later in detail with reference to FIGS. 9 and 14.

The operation management device 200 is a device capable of generally managing the process of loading the items 10 on the pallet 20.

More specifically, the operation management device 200 may manage information regarding the operators who use the operator devices 100, information regarding the items 10 loaded by the operator devices 100, and information regarding the pallet 20 where the items 10 are already loaded or to be loaded by the operators.

The operation management device 200 may output together loading sequences and arrangements transmitted from the simulation server 300 to the operator devices 100. The operation management device 200 may create an operation instruction document according to the loading sequence and arrangement for loading the items 10 on the pallet 20. Also, the operation management device 200 may print the created operation instruction document.

The operation management device 200 may be a stationary computing device such as, for example, a desktop, a server, or a workstation, but the present disclosure is not limited thereto. That is, alternatively, the operation management device 200 may be a mobile device such as, for example, a laptop, a smartphone, a tablet, a phablet, or a PDA.

The simulation server 300 may perform a simulated loading of the items 10 such that the items 10 can be loaded on a minimum number of pallets 20 over a minimum pallet area, and may provide a loading sequence and arrangement to the operator devices 100 according to the results of the simulated loading.

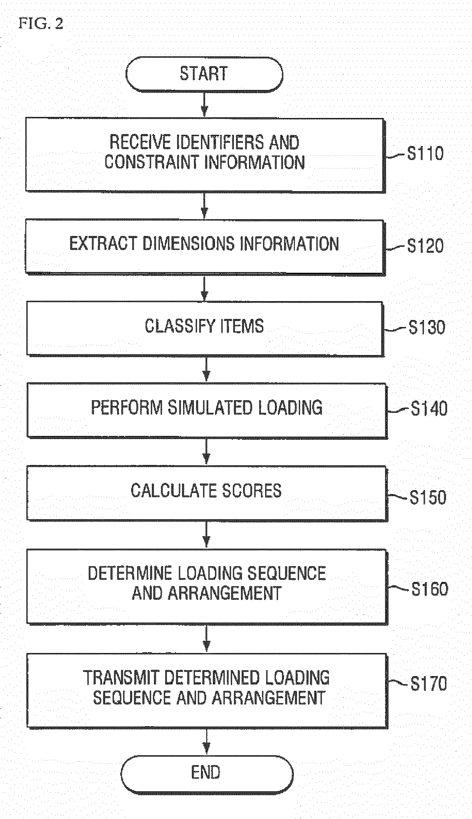

The simulation server 300 will be described later in detail with reference to FIGS. 2 through 4,13, and 15.

In short, the simulation system may provide the loading sequence and arrangement for loading the items 10 on a minimum number of pallets 20 over a minimum pallet area. Also, the simulation system may provide a step-by-step guide screen so as for each of the operators to easily load the items 10 on the pallet 20.

A guide providing method of the simulation server 300, according to an exemplary embodiment of the present disclosure, will hereinafter be described with reference to FIGS. 2 through 4. FIG. 2 is a flowchart illustrating a guide providing method according to an exemplary embodiment of the present disclosure.

Referring to FIG. 2, the simulation server 300 receives one or more item identifiers and item constraint information of one or more items 10 to be loaded and one or more pallet identifiers and pallet constraint information of one or more pallets 20 where the items 10 are to be loaded (S110).

The item identifiers, are strings for identifying the items 10. Each of the tem identifiers may consist of characters or numerals, but the present disclosure is not limited thereto.

The item constraint information includes a set of conditions that need to be considered in connection with the state of the items 10 before the loading of the items 10 on the pallets 20. For example, the item constraint information may include a maximum load that can be supported by the items 10, a direction in which the items 10 are to be loaded, whether visibility of the labels of the items 10 should be secured, whether the items 10 can be loaded in a tilted state, whether the items 10 can be double-packed, whether there exists a bundle attached to each of the items 10, and stock keeping unit (SKU) information of each of the items 10, but the present disclosure is not limited thereto.

The pallet identifiers are strings for identifying the pallets 20. Each of the pallet identifiers may consist of characters or numerals, but the present disclosure is not limited thereto.

The pallet constraint information includes a set of conditions that need to be considered in connection with the state of each of the pallets 20 before the loading of the items 10 on the pallets 20. For example, the pallet constraint information may include a maximum load of items 10 that can be loaded on each of the pallets 20, minimum margins that need to be secured on each of the pallets 20 to load the items 10, a maximum height to which the items 10 can be loaded on each of the pallets 20, and a maximum number of layers in which the items 10 can be loaded on each of the pallets 20, but the present disclosure is not limited thereto.

Thereafter, the simulation server extracts item dimensions information and pallet dimensions information from an item dimensions information database and a pallet dimensions information database, respectively, based on the item identifiers and the received pallet identifier (S120).

The item dimensions information database is a database in which dimensions information of each of the items 10 is stored. The pallet dimensions information database is a database in which dimensions information of each of the pallets 20 is stored. The item dimensions information database and the pallet dimensions information database may be provided in the simulation server 300, but the present disclosure is not limited thereto. That is, alternatively, the item dimensions information database and the pallet dimensions information database may be provided in a database server outside the simulation server 300.

The item dimensions information is information regarding the size or shape of each of the items 10. The item dimensions information may include the width, depth, height, weight, and price of each of the items 10, but the present disclosure is not limited thereto.

The pallet dimensions information is information regarding the size or shape of each of the pallets 20. The pallet dimensions information may include the width, depth, height, weight, maximum load, minimum margins, maximum height, and maximum layer quantity of each of the pallets 20, but the present disclosure is not limited thereto.

In an alternative exemplary embodiment, the simulation server 300 may receive the item dimensions information and the pallet dimensions information from the operator devices 100 or the operation management device 200.

Thereafter, the simulation server 300 classifies the items 10 corresponding to the item identifiers into one or more item groups based on the item dimensions information, the item constraint information, the pallet dimensions information, and the pallet constraint information (S130).

Each of the item groups is a group of items 10 that can be loaded together on a single pallet 20. That is, the item groups are the units of classification of the items 10 according to which pallet 20 the items 10 are to be loaded. One or more items 10 included in the same item group may be loaded together on a single pallet 20.

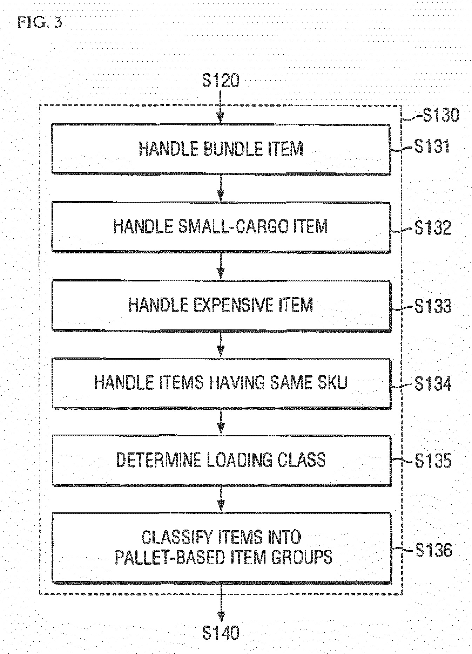

An item classification method of the simulation server 300, according to an exemplary embodiment of the present disclosure, will be described later in detail with reference to FIG. 3.

Thereafter, the simulation server 300 performs a simulated loading of items 10 included in each of the item groups on the pallets 20 based on the item dimensions information, the item constraint information, the pallet dimensions information, and the pallet constraint information by changing loading sequences and arrangements (S140).

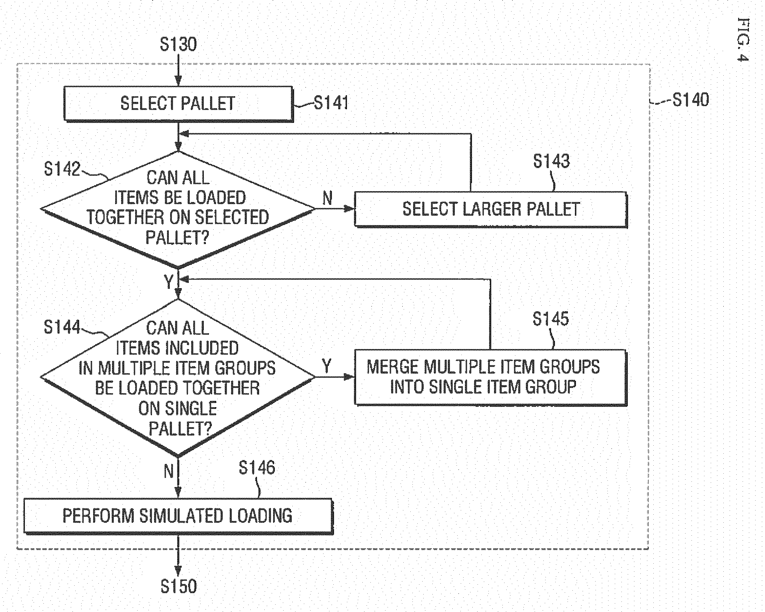

A simulated loading method of the simulation server 300, according to an exemplary embodiment of the present disclosure, will be described later in detail with reference to FIG. 4.

Thereafter, the simulation server 300 determines a loading sequence and arrangement for loading the items 10 corresponding to the item identifiers on the pallets 20 corresponding to the pallet identifiers based on the results of the simulated loading performed in S140. More specifically, the simulation server 300 calculates the score of each simulated loading result obtained by changing loading sequences and arrangements based on the number and area of pallets 20 used to load the items 10 (S150).

The score of each simulated loading result may be set such that the larger the remaining area of each of the pallets 20 with items 10 loaded thereon, the higher the score of a corresponding simulated loading result, but the present disclosure is not limited thereto. That is, alternatively, the score of each simulated loading result may be set such that the smaller the number of pallets 20 used to load the items 10, the lower the score of a corresponding simulated loading result, and that the larger the remaining area of each of the pallets 20 with items 10 loaded thereon, the lower the score of a corresponding simulated loading result.

Thereafter, the simulation server 300 determines an optimum loading sequence and arrangement based on the calculated score of each simulated loading result (S160). More specifically, the simulation server 300 selects a simulated loading method based on the calculated score of each simulated loading result. If the score of each simulated loading result is set such that as the number of pallets 20 used to load the items 10 decreases and the remaining area of each of the pallets 20 with items 10 loaded thereon increases, the score of a corresponding simulated loading result increases, the simulation server 300 may select a simulated loading method that produces a simulated loading result with a highest score. On the other hand, if the score of each simulated loading result is set such that as the number of pallets 20 used to load the items 10 decreases and the remaining area of each of the pallets 20 with items 10 loaded thereon increases, the score of a corresponding simulated loading result decreases, the simulation server 300 may select a simulated loading method that produces a simulated loading result with a lowest score.

The simulation server 300 may determine a loading sequence and arrangement used by the selected simulated loading method as the loading sequence and arrangement for loading the items 10 corresponding to the item identifiers on the pallets 20 corresponding to the pallet identifiers.

Thereafter, the simulation server 300 transmits the determined loading sequence and arrangement to the operator devices 100 or the operation management device 200 (S170). More specifically, if the item identifiers and the pallet identifier are provided by the operator devices 100, the simulation server 300 may transmit the determined loading sequence and arrangement to both the operator devices 100 and the operation management server 200. On the other hand, if the item identifiers and the pallet identifier are provided by the operation management device 200, the simulation server 300 may transmit the determined loading sequence and arrangement only to the operation management server 200.

An item classification method of the simulation server 300, according to an exemplary embodiment of the present disclosure, will hereinafter be described FIG. 3 is a flowchart illustrating a method of classifying items according to an exemplary embodiment of the present disclosure.

Referring to FIG. 3, the simulation server 300 handles at least one target item 10 to be subjected to exception handling, from among other items 10, using a predefined exception handling method.

The target item 10 may be an item 10 that can be loaded on a pallet 20 only after being subjected to a third additional operation. For example, the target item 10 may be an item 10 having a bundle attached thereto, an item 10 having dimensions that that do not measure up to predefined critical dimensions, an item 10 having a cost value greater than a predefined critical cost value, or an item 10 sharing the same SKU with another item 10, but the present disclosure is not limited thereto. The exception handling method additionally performs a third operation on the target item 10 before the loading of the target item 10 on a pallet 20. For example, the exception handling method may include classifying the target item 10 and a bundle of the target item 10 into a sub-item group, classifying the target item 10 into a small-cargo item group to be excluded from pallet loading, or double-packing the target item 10, but the present disclosure is not limited thereto.

The handling of the target item 10 by the simulation server 300 will hereinafter be described in further detail

The simulation server 300 handles an item 10 having a bundle attached thereto (S131). More specifically, if there exists a first item 10 having a bundle attached thereto, the simulation server 300 classifies the first item 10 and the bundle of the first item 10 into a single sub-item group.

The term "bundle", as used herein, denotes an object that is attached to, and can thus be provided along with, an item 10. For example, a bundle may be instructions or software provided along with an item 10, but the present disclosure is not limited thereto.

The term "sub-item group", as used herein, denotes a group of items 10 that need to be loaded on the same pallet 20. Thus, one or more items 10 included in the same sub-item group can be loaded on the same pallet 20.

The simulation server 300 handles a small-cargo item 10 (S132). More specifically, if there exists a first item 10 having dimensions that do not measure up to the predefined critical dimensions, the simulation server 300 classifies the first item 10 into a small-cargo item group.

The critical dimensions are a standard for sorting out items 10 that can lower entire loading efficiency when they are loaded on a pallet 20. The critical dimensions may be included in the pallet constraint information, but the present disclosure is not limited thereto. That is, alternatively, the critical dimensions may be preset in the simulation server 300. The term "small-cargo item group", as used herein, denotes a group of items 10 that are not to be loaded on a pallet 20. Thus, one or more items 10 included in the small-cargo item group are excluded from pallet loading.

The simulation server 300 handles an expensive item 10 (S133). If there exists a first item 10 having a cost value greater than a predefined critical cost value, the simulation server 300 classifies the first item 10 into a double-packing item group.

The term "critical cost value", as used herein, denotes the cost of an item 10 that needs to be subjected to intensive care in consideration of the range of responsibilities for any loss, destruction, or damage. The critical cost value may be included in the pallet constraint information, but the present disclosure is not limited thereto. That is, the critical cost value may be preset in the simulation server 300. The term "double-packing item group", as used herein, denotes a group of items 10 that need to be double-packed to be loaded on a pallet 20. Thus, one or more items 10 included in the double-packing item group may be double-packed by the operators who use the operator devices 100 and may then be loaded on a pallet 20.

The simulation server 300 handles items 10 sharing the same SKU (S134). More specifically, if there exist a first item 10 and a second item 10 having the same SKU, the simulation server 300 classifies the first item 10 and the second item 10 into a single sub-item group.

The simulation server 300 determines the loading class of each of the items 10 (S135). More specifically, the simulation server 300 identifies a layer of a pallet 20 in which each of the items 10 can be loaded based on item dimensions information, item constraint information, pallet dimensions information, and pallet constraint information. Then, the simulation server 300 determines the loading class of each of the items 10 based on the identified pallet layer. Particularly, the simulation server 300 determines the loading class of an item 10 included in the double-packing item group based on item dimensions information and item constraint information of the corresponding item 10 in a double-packed state.

A loading class is a string for identifying a layer of a pallet 20 in which each of the items 10 can be loaded. For example, an item 10 having a loading class of 1 may be loaded in a first layer of a pallet 20.

Thereafter, the simulation server 300 classifies the items 10 into one or more pallet-based item groups based on the determined loading class of each of the items 10, the item dimensions information and item constraint information of each of the items 10, pallet dimensions information and pallet constraint information of each pallet 20 (S136). A method of classifying items 10 into one or more pallet-based item groups, as performed by the simulation server 300, will hereinafter be described.

The simulation server 300 may classify items 10 corresponding to the determined loading class into one or more item groups such that the items 10 can be evenly distributed between the item groups. For example, the simulation server 300 may sequentially allocate items 10 determined to be of a first loading class, one-by-one, between the item groups, but the present disclosure is not limited thereto.

The simulation server 300 may classify the items 10 corresponding to the determined loading class into one or more item groups such that the corresponding items 10 can be evenly distributed between the item groups in terms of the sum of weights. For example, the simulation server 300 may classify the items 10 corresponding to the determined loading class into a first item group and a second item group such that the sum of the weights of items 10 included in the first item group may be equal to the sum of the weights of items 10 included in the second item group. In this example, if the difference, if any, between the sum of the weights of the items 10 included in the first item group and the sum of the weights of the items 10 included in the second item group exceeds a predefined threshold level, the simulation server 300 may swap one of the items 10 included in the first item group with one of the items 10 included in the second item group, but the present disclosure is not limited thereto.

A simulated loading method of the simulation server 300, according to an exemplary embodiment of the present disclosure, will hereinafter be described. FIG. 4 is a flowchart illustrating a simulated loading method according to an exemplary embodiment of the present disclosure.

Referring to FIG. 4, the simulation server 300 matches each item group with a pallet 20 with a minimum area for loading a corresponding item group.

More specifically, the simulation server 300 selects a first pallet 20 having a smallest area from among one or more pallets 20 (S141). Thereafter, the simulation server 300 determines whether all items 10 included in a first item group can be loaded together on the first pallet 20 (S142). In response to a determination being made that not all the items 10 included in the first item group can be loaded together on the first pallet 20, the simulation server 300 selects a second pallet 20 having a larger area than the first pallet 20 (S143). Thereafter, the simulation server 300 determines whether all the items 10 included in the first item group can be loaded together on the second pallet 20. In this manner, the simulation server 300 can match each item group with a pallet 20 having a minimum area for loading a corresponding item group by sequentially selecting one from among a plurality of pallets 20 in the order from a pallet 20 with a smallest area to a pallet 20 with a largest area and determining whether all items 10 included in the corresponding item group can be loaded together on the selected pallet 20.

Thereafter, the simulation server 300 determines whether items 10 included in two or more item groups can be loaded together on a single pallet 20 based on the remaining area of the single pallet 20 (S144). The term "remaining area ofa pallet", as used herein, denotes the remaining area, available for loading, of a pallet 20 with items 10 already loaded thereon. In response to a determination being made that items 10 included in two or more item groups can be loaded together on a single pallet 20, the simulation server 300 merges the two or more item groups into a single item group (S145). Thereafter, the simulation server 300 performs a simulated loading of the items 10 included in each item group on a selected pallet 20 for a corresponding item group (S146). More specifically, the simulation server 300 may perform a simulated loading of the items 10 included in each item group on the selected pallet 20 for the corresponding item group by changing loading sequences and arrangements. A loading sequence and arrangement for use in the simulated loading of items 10 on a pallet 20 will hereinafter be described.

The simulation server 300 may perform a simulated loading of one or more items 10 on a pallet 20 using generalized 4-block heuristic. For example, the simulation server 300 divides a first layer of a selected pallet 20 for a first item group into four blocks. The simulation server 300 performs a simulated loading of items 10 included in the first item group in the first layer while changing the direction in which the items 10 are arranged to differ from one block to another block of the first layer. More specifically, the simulation server 300 may arrange the items 10 in each of the four blocks by rotating the direction of the arrangement of the items 10 in one direction, in which case, the direction of the arrangement of the items 10 may differ from one block to another block of the first layer.

The simulation server 300 may perform a simulated loading of one or more items 10 on a pallet 20 in such a manner that the center of gravity of the pallet 20 with the items 10 loaded thereon can be lowered as much as possible. For example, the simulation server 300 may perform a simulated loading of the items 10 included in the first item group on the selected pallet 20 for the first item group in such a manner that the angle between a first side of a first item included in the first item group and a first side of the selected pallet 20 for the first item group or a first side of a second item that is placed in contact with the first side of the first item may decrease.

Also, the simulation server 300 may perform a simulated loading of the items 10 included in each item group in such a manner that the maximum height to which the items 10 included in each item group are loaded may become uniform throughout one or more pallets 20. For example, the simulation server 300 may perform simulated loading such that the height to which items 10 are loaded on a first pallet 20 may become equal to the height to which items 10 are loaded on a second pallet 20. In this example, if the difference, if any, between the height to which items 10 are loaded on the first pallet 20 and the height to which height to which items 10 are loaded on the second pallet 20 exceeds a predefined threshold level, the simulation server 300 may perform a simulated loading of the items 10 on the first pallet 20 and the second pallet 20 again according to a new loading sequence or arrangement.

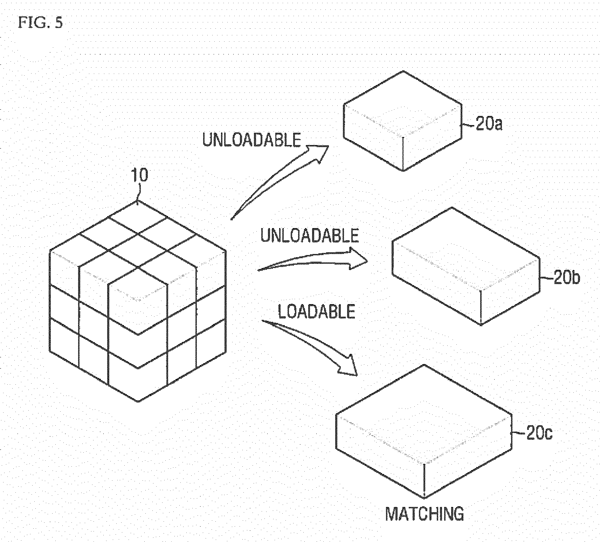

FIG. 5 is a schematic view illustrating a pallet matching method according to an exemplary embodiment of the present disclosure. Referring to FIG. 5, the simulation server 300 may select a pallet having a minimum area for loading one or more items 10 included in a first item group, i.e., a third pallet 20c, and may match the first item group with the third pallet 20c.

More specifically, the simulation server 300 may select a first pallet 20a having a smallest area from among a plurality of pallets 20a, 20b, and 20c.

Thereafter, the simulation server 300 may determine whether all the items 10 included in the first item group can be loaded together on the first pallet 20a. Since not all the items 10 included in the first item group can be loaded together on the first pallet 20a, the simulation server 300 may select a second pallet 20b having a larger area than the first pallet 20a.

Thereafter, the simulation server 300 may determine whether all the items 10 included in the first item group can be loaded together on the second pallet 20b. Since not all the items 10 included in the first item group can be loaded together on the second pallet 20b, the simulation server 300 may select the third pallet 20c having a larger area than the second pallet 20b.

Since all the items 10 included in the first item group can be loaded together on the third pallet 20c, the simulation server 300 may match the third pallet 30c to the first item group as a minimum-area pallet for loading all the items 10 included in the first item group.

Accordingly, the simulation server 300 may match each item group with a minimum area pallet 20 for loading all items included in a corresponding item group.

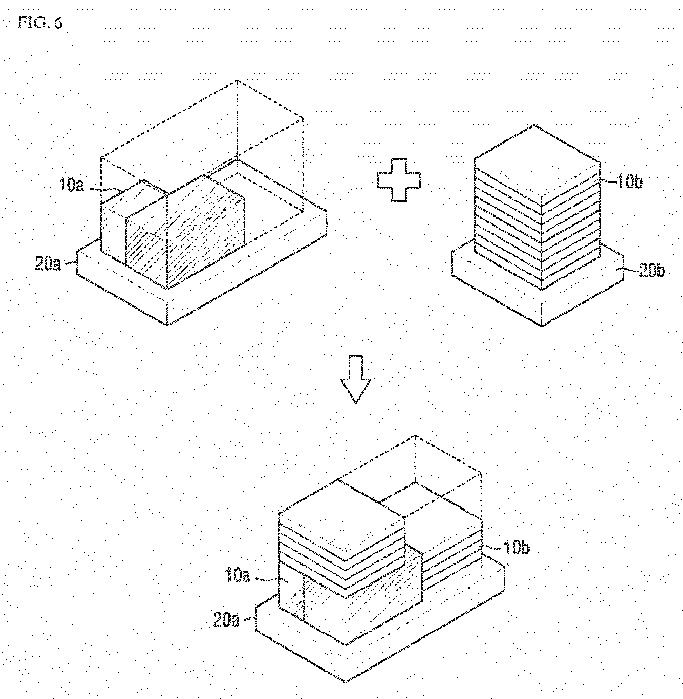

FIG. 6 is a schematic view illustrating a method of merging item groups according to an exemplary embodiment of the present disclosure. Referring to FIG. 6, the simulation server 300 may merge a first item group and a second item group together based on the remaining areas of the first pallet 20a and the second pallet 20b.

More specifically, the simulation server 300 may identify a first remaining area of the first pallet 20a with items 10a loaded thereon. The simulation server 300 may determine whether items 10b included in a second item group can all be loaded in the first remaining area.

Also, the simulation server 300 may identify a second remaining area of the second pallet 20b with the items 10b loaded thereon. The simulation server 300 may determine whether the items 10a included in the first item group can all be loaded in the second remaining area.

Since all the items 10b included in the second item group can be loaded in the identified first remaining area, the simulation server 300 may merge the first item group and the second item group into a single item group. Then, the simulation server 300 may match the single merged item group with the first pallet 20a as a pallet for loading all the items included in the single merged item group, i.e., the items 10a and the items 10b.

Accordingly, the simulation server 300 may load multiple groups of items 10 on a single pallet 20 and may thus minimize the number of pallets 20 for loading items 10.

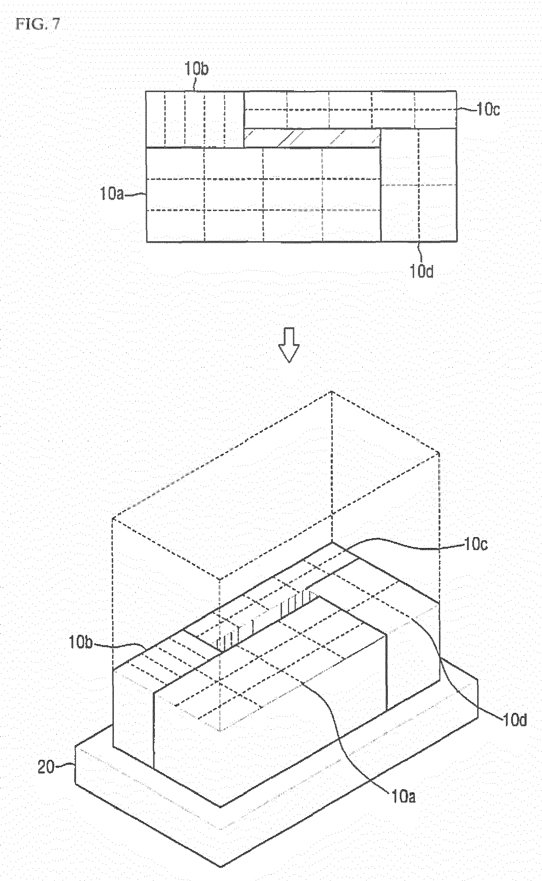

FIG. 7 is a schematic view illustrating an item arrangement pattern according to an exemplary embodiment of the present disclosure. Referring to FIG. 7, the simulation server 300 may load items 10 in each layer of a pallet 20 using generalized 4-block heuristic.

More specifically, the simulation server 300 may divide each layer of the pallet 20 into four blocks 10a, 10b, 10c, and 10d. The simulation server 300 may perform a simulated loading of items 10 in each of the four blocks 10a, 10b, 10c, and 10d in such a manner that the direction in which the items 10 are arranged may differ from one block to another block of each layer of the pallet 20. The simulation server 300 may rotate the direction in which the items 10 are arranged in a pinwheel fashion such that the direction in which the items 10 are arranged may differ from one block to another block of each layer of the pallet 20.

Accordingly, the simulation server 300 may improve the use of a loading space and the stability of items 10 by loading the items 10 using generalized 4-block heuristic.

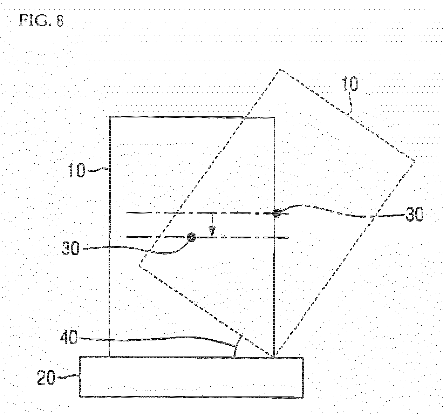

FIG. 8 is a schematic view illustrating the center of gravity of a pallet according to an exemplary embodiment of the present disclosure. Referring to FIG. 8, the simulation server 300 may measure a tipping angle 40 of a first item 10 and may lower a center 30 of gravity of a pallet 20 based on the tipping angle 40.

More specifically, the simulation server 300 may measure the tipping angle 40 of the first item 10. The tipping angle 40 is the angle between a first side of the first item 10 and either a first side of the pallet 20 where the first item 10 can be loaded or a first side of a second item. The simulation server 300 finds a location where the tipping angle 40 reaches its minimum. The simulation server 300 may determine the found location as a loading location for the first item 10.

Accordingly, the simulation server 300 may determine the loading location for the first item 10 based on the location where the tipping angle 40 reaches its minimum and may thus lower the center 30 of gravity of the pallet 20 with the first item 10 loaded thereon.

A guide providing method of the operator devices 100, according to an exemplary embodiment of the present disclosure, will hereinafter be described with reference to FIG. 9. FIG. 9 is a flowchart illustrating a guide providing method according to another exemplary embodiment of the present disclosure.

Referring to FIG. 9, the operator devices 100 receive one or more item identifiers and item constraint information of one or more items 10 to be loaded and one or more pallet identifiers and pallet constraint information of one or more pallets 20 where the items 10 can be loaded (S210). More specifically, the operator devices 100 may receive the item identifiers, the item constraint information, the pallet identifiers, and the pallet constraint information from their operators, but the present disclosure is not limited thereto. That is, alternatively, the operator devices 100 may receive the item identifiers, the item constraint information, the pallet identifiers, and the pallet constraint information from the operation management device 200.42103183901026

The operator devices 100 transmit the item identifiers, the item constraint information, the pallet identifiers, and the pallet constraint information to the simulation server 300 (S230). Thereafter, the operator devices 100 may receive a loading sequence and arrangement for loading the items 10 on the pallets 20 from the simulation server 300 (S250). The operator devices 100 may also receive the coordinates of the center of gravity of each of the pallets 20 with the items 10 loaded thereon from the simulation server 300.

Thereafter, the operator devices 100 may provide a step-by-step guide screen for loading the items 10 on each of the pallets 20 according to the received loading sequence and arrangement (S270). For example, if a first item 10 is ahead of a second item 10 in the received loading sequence, the operator devices 100 may provide an image showing a first pallet 20 with the first item 10 loaded thereon and then an image showing the first pallet 20 with the second item 10 further loaded thereon.

If a first layer of the first pallet 20 is ahead of a second layer of the first pallet 20 in the received loading sequence, the operator devices 100 may provide an image showing the first pallet 20 with items 10 loaded in the first layer thereof and then an image showing the first pallet 20 with items 10 further loaded in the second layer thereof.

The operator devices 100 may provide an image showing the center of gravity of each of the pallets 20 based on the coordinates received from the simulation server 300. Also, if the coordinates received from the simulation server 300 fall outside a predefined critical safety zone, the operator devices 100 may provide an image showing a tie down for fixing the items 10 onto each of the pallets 20.

The critical safety zone is a zone where the center of gravity of each of the pallets 20 should reside in order for the items 10 to be stably loaded on each of the pallets 20. That is, the critical safety zone is a standard for determining whether the items 10 are stably loaded on each of the pallets 20. Items 10 loaded on a pallet 20 whose center of gravity falls within the critical safety zone are highly unlikely to fall off the pallet 20 and be damaged. On the other hand, items 10 loaded on a pallet 20 whose center of gravity falls outside the critical safety zone are highly likely to fall off the pallet 20 and be damaged unless properly coupled to the pallet 20 with a tie-down. The critical safety zone may be included in the pallet constraint information, but the present disclosure is not limited thereto. That is, alternatively, the critical safety zone may be preset in the operator devices 100.

FIGS. 10 through 12 are schematic views illustrating guide screens according to some exemplary embodiments of the present disclosure.

Referring to FIG. 10, in a case in which there are three items 10a, 10b, and 10c to be loaded on a pallet 20, the operator devices 100 may provide an image 20 showing a pallet 20 with a highest-priority item, i.e., the item 10a, loaded thereon according to a predetermined loading sequence. Thereafter, the operator devices 100 may provide an image 20 showing the pallet 20 with a second highest-priority item, i.e., the item 10b, further loaded thereon according to the predetermined loading sequence. Thereafter, the operator devices 100 may provide an image 20 showing the pallet 20 with a lowest-priority item, i.e., the item 10c, further loaded thereon according to the predetermined loading sequence.

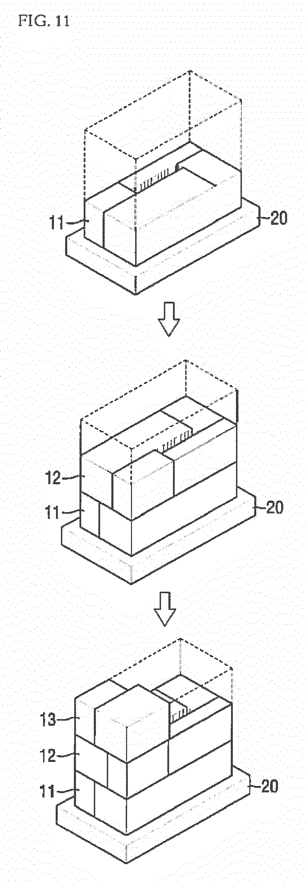

Referring to FIG. 11, in a case in which there are three layers 11, 12, and 13 of a pallet 20 where items 10 are to be loaded, the operator devices 100 may provide an image showing the pallet 20 with items 10 loaded in a highest-priority layer thereof, i.e., the layer 11, according to a predetermined loading sequence. Thereafter, the operator devices 100 may provide an image showing the pallet 20 with items 10 loaded in a second highest-priority layer thereof, i.e., the layer 12, according to the predetermined loading sequence. Thereafter, the operator devices 100 may provide an image showing the pallet 20 with items 10 loaded in a lowest-priority layer thereof, i.e., the layer 13, according to the predetermined loading sequence.

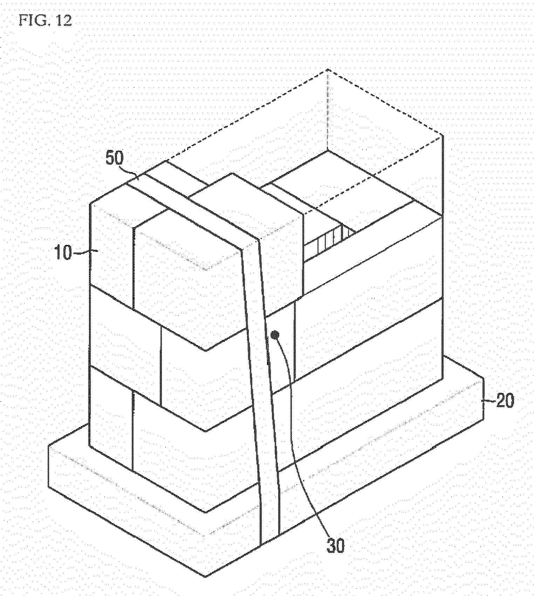

Referring to FIG. 12, the operator devices 100 may provide an image showing a center 30 of gravity of a pallet 20 based on coordinates received from the simulation server 300. If the received coordinates fall outside a predefined critical safety zone, the operator devices 100 may also provide an image of a tie-down 50 for fixing items 10 onto the pallet 20.

Accordingly, the operator devices 100 may provide a step-by-step guide screen for facilitating the loading of items 10 on a pallet 20 and may thus improve the operators' loading efficiency and the stability of the items 10 loaded on the pallet 20.

The methods that have been described above with reference to FIGS. 2 through 12 can be executed by a computer program implemented as computer-readable code. The computer program may be transmitted from a first computing device to a second computing device via a network such as the Internet and may then be installed and used in the second computing device. Examples of the first and second computing devices include stationary computing devices such as a desktop, a server, a workstation, and the like, mobile computing devices such as a smartphone, a tablet, a phablet, a laptop, and the like, and wearable computing devices such as a smart watch, smart glasses, a smart band, and the like.

The logic configurations of the simulation server 300 and the operator devices 100 will hereinafter be described with reference to FIGS. 13 through 15. FIG. 13 is a block diagram of the simulation server 300. Referring to FIG. 13, the simulation server 300 may include a server communication unit 310, a server storage unit 320, an item grouping unit 330, and a simulated loading unit 340.

The server communication unit 310 transmits data to or receives data from the operator devices 100 or the operation management device 200 via a network. More specifically, the server communication unit 310 may receive one or more item identifiers and item constraint information of one or more items 10 to be loaded and one or more pallet identifiers and pallet constraint information of one or more pallets 20 where the items 10 can be loaded. The server communication unit 310 may transmit a loading sequence and arrangement for loading the items 10 on the pallets 20 to the operator devices 100 or the operation management device 200.

Thereafter, the server storage unit 320 stores data necessary for the operation of the simulation server 300. More specifically, the server storage unit 320 may include an item dimensions information database 323 and a pallet dimensions information database 326. The item dimensions information database 323 is a storage where item dimensions information of each of the items 10 is stored. The pallet dimensions information database 326 is a storage where pallet dimensions information of each of the pallets 20 is stored.

Thereafter, the item grouping unit 330 classifies the items 10 into one or more item groups. Each of the item groups is a group of items 10 that can be loaded together on a single pallet 20. That is, the item groups are the units of classification of the items 10 according to which pallet 20 the items 10 are to be loaded. One or more items 10 included in the same item group may be loaded together on a single pallet 20.

More specifically, the item grouping unit 330 handles a target item 10 to be subjected to exception handling, from among other items 10, using a predefined exception handling method. The target item 10 may be an item 10 that can be loaded on a pallet 20 only after being subjected to a third additional operation. For example, the target item 10 may include an item 10 having a bundle attached thereto, an item 10 having dimensions that that do not measure up to predefined critical dimensions, an item 10 having a cost value greater than a predefined critical cost value, or an item 10 sharing the same SKU with another item 10, but the present disclosure is not limited thereto. The exception handling method is a third operation to be additionally performed on the target item 10 before the loading of the target item 10 on a pallet 20. For example, the exception handling method may include classifying the target item 10 and a bundle of the target item 10 into a sub-item group, classifying the target item 10 into a small-cargo item group to be excluded from pallet loading, or double-packing the target item 10, but the present disclosure is not limited thereto.

The item grouping unit 330 identifies a layer of a pallet 20 in which each of the items 10 can be loaded based on the item dimensions information, the item constraint information, the pallet dimensions information, and the pallet constraint information. Then, the item grouping unit 330 determines the loading class of each of the items 10 based on the identified pallet layer.

The item grouping unit 330 classifies the items 10 into one or more pallet-based item groups based on the determined loading class of each of the items 10, the item dimensions information, the item constraint information, the pallet dimensions information, and the pallet constraint information.

The simulated loading unit 340 performs a simulated loading of items 10 included in each of the item groups on the pallets 20, based on the item dimensions information, the item constraint information, the pallet dimensions information, and the pallet constraint information by changing loading sequences and arrangements.

More specifically, the simulated loading unit 340 selects a pallet 20 having a minimum area for loading each of the item groups from among the pallets 20.

The simulated loading unit 340 determines whether items 10 included in two or more groups can be loaded together on a single pallet 20. In response to a determination being made that items 10 included in two or more groups can be loaded on a single pallet 20, the simulated loading unit 340 merges the two or more item groups into a single item group. Thereafter, the simulated loading unit 340 selects a pallet 20 having a minimum area for loading all the items included in the single merged item group.

The simulated loading unit 340 performs a simulated loading of loading the items 10 included in each of the item groups on the selected pallet 20 for a corresponding item group. The simulated loading unit 340 may load one or more items 10 on a pallet 20 using generalized 4-block heuristic. The simulated loading unit 340 may perform a simulated loading of one or more items 10 on a pallet 20 such that the center of gravity of the pallet 20 with the items 10 loaded thereon can be lowered as much as possible.

FIG. 14 is a block diagram of an operator device 100 according to an exemplary embodiment of the present disclosure. Referring to FIG. 14, the operator device 100 may include a device communication unit 110, a device input unit 120, a device output unit 130, and a device control unit 140.

The device communication unit 110 transmits data to or receives data from the operation management device 200 or the simulation server 300 via a network. More specifically, the device communication unit 110 may transmit one or more item identifiers and item constraint information of one or more items 10 to be loaded and one or more pallet identifiers and pallet constraint information of one or more pallets 20 where the items 10 can be loaded. The device communication unit 110 may receive a loading sequence and arrangement for loading the items 10 on the pallets 20 from the simulation server 300.

The device input unit 120 receives data necessary for the operation of the operator device 100. More specifically, the device input unit 120 may receive the item identifiers, the item constraint information, the pallet identifiers, and the pallet constraint information.

The device output unit 130 may output an image showing a pallet 20 with items 10 loaded thereon. More specifically, the device output unit 130 may output a step-by-step guide screen for loading one or more items 10 on one or more pallets 20.

The device control unit 140 controls the device communication unit 110, the device input unit 120, and the device output unit 130. More specifically, the device control unit 140 receives the item identifiers, the item constraint information, the pallet identifiers, and the pallet constraint information via the device input unit 110.

The device control unit 140 transmits the item identifiers, the item constraint information, the pallet identifiers, and the pallet constraint information to the simulation server via the device communication unit 110. The device control unit 140 receives the loading sequence and arrangement for loading the items 10 on the pallets 20 from the simulation server 300 via the device communication unit 110.

The device control unit 140 transmits a step-by-step guide screen for loading the items 10 on the pallets according to the received loading sequence and arrangement via the device output unit 130.

For example, if a first item 10 is ahead of a second item 10 in the received loading sequence, the device control unit 140 may output an image showing a first pallet 20 with the first item 10 loaded thereon and then an image showing the first pallet 20 with the second item 10 further loaded thereon. For example, if a first layer of the first pallet 20 is ahead of a second layer of the first pallet 20 in the received loading sequence, the device control unit 140 may output an image showing the first pallet 20 with items 10 loaded in the first layer thereof and then an image showing the first pallet 20 with items 10 further loaded in the second layer thereof.

The device control unit 140 may provde an image showing the center of gravity of each of the pallets 20. If the coordinates of the center of gravity of each of the pallets 20 fall outside a predefined critical safety zone, the device control unit 140 may output an image showing a tie-down for fixing the items 10 onto each of the pallets 20.

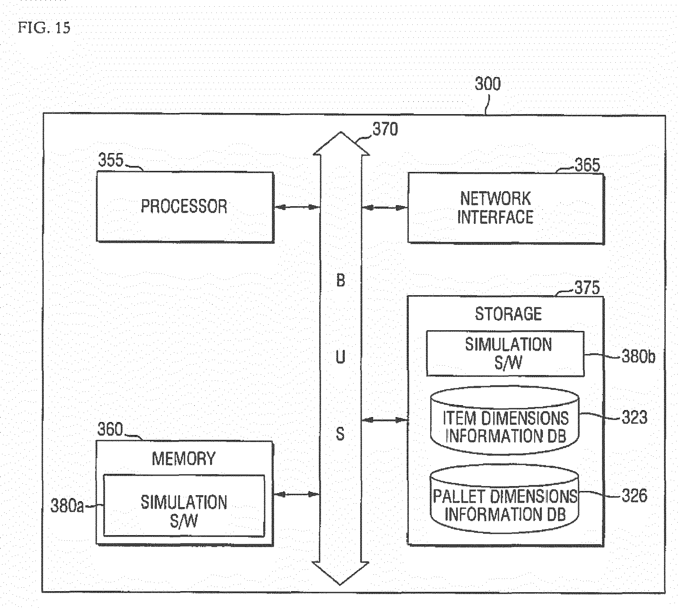

FIG. 15 is a hardware configuration view of the simulation server 300. Referring to FIG. 15, the simulation server 300 may include a processor 355, a memory 360, a network interface 365, a data bus 370, and a storage 375.

Simulation software data 380a that implements a guide providing method may reside in the memory 360. The network interface 365 may transmit data to or receive data from the operator devices 100 and the operation management device 200. The data bus 370, which is connected to the processor 355, the memory 360, the network interface 365, and the storage 375, is a path via which data is transmitted among the processor 355, the memory 360, the network interface 365, and the storage 375.

The storage 375 may store an application programming interface (API), a library, or a resource file for executing a computer program. The storage 375 may include the item dimensions information database 323 and the pallet dimensions information database 326 and may store simulation software data 380b.

More specifically, the storage 375 may store a computer program including instructions acquiring item dimensions information and item constraint information of items and pallet dimensions information and pallet constraint information of pallets via the network interface 365, instructions classifying the items into a plurality of item groups based on the acquired information, instructions matching each of the item groups with a pallet for loading items included in a corresponding item group, instructions merging multiple item groups if all items included in the multiple item groups can be loaded together on a single pallet, instructions performing a simulated loading of items included in each of the item groups on a pallet matched to a corresponding item group by changing loading sequences and arrangements, and instructions determining a loading sequence and arrangement for loading the items included in each of the item groups on the pallet matched to the corresponding item group.

## Claims

1. A guide providing method comprising:
acquiring item dimensional information, item constraint information, pallet dimensional information and pallet constraint information;
classifying a plurality of items into a plurality of item groups based on the acquired information;
matching each of the plurality of item groups with a corresponding pallet of a plurality of pallets;
determining whether a first item group of the plurality of item groups and a second item group of the plurality of item groups can be loaded together on a matched pallet of the plurality of pallets;
merging the first item group and the second item group based on the determining and a remaining area of the matched pallet;
performing a simulated loading of each of the plurality of items on the matched pallet by changing loading sequences and arrangements; and
determining a loading sequence and arrangement for loading the plurality of items included in each of the item groups on the matched pallet.

2. The guide providing method of claim 1, wherein the classifying the items, comprises:
determining one or more items of the plurality of items to be subjected to exception handling;
handling the one or more items to be subjected to exception handling using a predefined exception handling method;
identifying a layer of the pallet in which each of the plurality of items can be loaded based on the acquired information;
determining a loading class of each of the plurality of items based on the identified pallet layer; and
classifying the plurality of items into one or more pallet-based item groups based on the determined loading class of each of the plurality of items.

3. The guide providing method of claim 2, wherein the classifying the items into the one or more pallet-based item groups comprises classifying items determined to be of a first loading class such that the corresponding items can be evenly distributed between the item groups.

4. The guide providing method of claim 2, wherein the classifying the items into the one or more pallet-based item groups comprises classifying the plurality of items such that a sum of weights of items included in a first item group is equal to a sum of weights of items included in a second item group.

5. The guide providing method of claim 1, wherein the matching each of the plurality of item groups with the corresponding pallet comprises:
selecting a first pallet of the plurality of pallets having a smallest area based on the pallet dimensions information;
determining whether all items included in a first item group can be loaded together on the first pallet; and
selecting a second pallet having a larger area than the first pallet when not all the items included in the first item group can be loaded together on the first pallet.

6. The guide providing method of claim 1, wherein the performing the simulated loading of each of the plurality of items comprises dividing a first layer of the matched pallet into a plurality of blocks and performing a simulated loading of items included in the first item group in the first layer while changing a direction in which the corresponding items are arranged for every block of the first layer.

7. The guide providing method of claim 1, wherein the performing the simulated loading of each of the plurality of items comprises performing a simulated loading of items included in a first item group on the matched pallet such that a center of gravity of the corresponding pallet with items loaded thereon is lowered.

8. The guide providing method of claim 11, wherein the performing the simulated loading of the items included in the first item group comprises loading each of the plurality of items included in the first item group such that an angle between a first side of a first item included in the first item group and a first side of a pallet that contacts the first side of the first item is reduced.

9. The guide providing method of claim 1, wherein the performing the simulated loading of each of the plurality of items comprises performing a simulated loading of the items on a first pallet and a second pallet such that a height to which the items can be loaded on the first pallet is equal to a height to which the items can be loaded on the second pallet.

10. The guide providing method of claim 1, wherein the determining the loading sequence and arrangement for loading the plurality of items included in each of the item groups on the matched pallet comprises:
calculating a score of each simulated loading result performed by changing loading sequences and arrangements based on a number and area of pallets used to load the items;
selecting a simulated loading method based on the calculated score of each simulated loading result; and
determining the loading sequence and arrangement for loading the plurality of items included in each of the item groups on the matched pallet.

11. A guide providing method comprising:
receiving an item identifier and item constraint information for a plurality of items, and a pallet identifier and pallet constraint information of a pallet;
transmitting the received identifiers and information to a simulation server;
receiving a loading sequence and arrangement for loading the plurality of items on the pallet from the simulation server; and
providing a step-by step guide screen for loading the plurality of items on the pallet according to the received loading sequence and sequence.

12. The guide providing method of claim 11, wherein the providing the guide screen comprises, when a first item is before a second item in the received loading sequence, providing an image showing the pallet with the first item loaded thereon, and then providing an image showing the pallet with the second item further loaded thereon.

13. The guide providing method of claim 11, wherein the providing the guide screen, comprises, when a first layer of the pallet is before a second layer of the pallet in the received loading sequence, provding an image showing the pallet with items loaded in the first layer thereof, and then providing an image showing the pallet with items further loaded in the second layer thereof.

14. The guide providing method of claim 11, wherein the receiving the loading sequence and arrangement for loading the plurality of items on the pallet comprises receiving coordinates of a center of gravity of the pallet with the items loaded thereon from the simulation server; and
the providing the guide screen comprises providing an image showing the center of gravity of the pallet based on the received coordinates.

15. An operator device comprising:
a device input interface configured to receive data from an operator;
a communicator configured to transmit data to and receive data from a simulation server via a network;
a display configured to output an image indicating a pallet with a plurality of items loaded thereon; and
a controller configured to receive item identifiers and item constraint information of the plurality of items, and a pallet identifier and pallet constraint information of the pallet via the device input interface, control the communicator to transmit the received identifiers and information, receive a loading sequence and arrangement for loading the plurality of items on the pallet via the communicator, and control the display to output a step-by-step guide screen for loading the plurality of items on the pallet.
